# FASCICULE DE BREVET EUROPEEN

(11) **EP 0 516 804 B1**
(45) Date de publication et mention de la délivrance du brevet: **24.01.1996**
(21) Numéro de dépôt: 92902267.1
(22) Date de dépôt: 17.12.1991
(51) Int. Cl.: C08J 7/00, C23C 16/40

(54) **PROCEDE DE DEPOT D'UNE COUCHE D'OXYDE DE SILICIUM LIEE A UN SUBSTRAT EN MATERIAU POLYMERE**
VERFAHREN ZUR ABSCHEIDUNG EINER AN EINEM POLYMEREN MATERIAL BEFESTIGTEN SILIZIUMOXYDSCHICHT
METHOD OF DEPOSITING A SILICON OXIDE FILM BONDED TO A POLYMER SUBSTRATE

(30) Priorité: 17.12.1990 FR 9015757
(43) Date de publication de la demande: 09.12.1992
(73) Titulaire: L'AIR LIQUIDE, SOCIETE ANONYME POUR L'ETUDE ET L'EXPLOITATION DES PROCEDES GEORGES CLAUDE, F-75321 Paris Cédex 07 (FR)
(72) Inventeur: GASTIGER, Michel, F-91400 Orsay (FR); SLOOTMAN, Franciscus, F-78150 Le-Chesnay (FR); BOUARD, Pascal, F-91210 Draveil (FR); WILLEMOT, Antoine, F-92300 Sceaux (FR)
(74) Mandataire: Caen, Thierry Alain
(86) Numéro de dépôt international: FR9101017
(87) Numéro de publication internationale: WO9211312

(56) Documents cités:
- EP-A- 0 311 432
- FR-A- 2 534 262
- GB-A- 1 135 749
- GB-A- 1 188 642
- US-A- 4 328 646
- US-A- 4 927 704

## Description

L'invention concerne un procédé de dépôt d'une couche d'oxyde de silicium liée à un substrat en matériau polymère.

Des matériaux polymères, synthétiques ou naturels, tels les polyoléfines, sont couramment utilisés dans diverses industries. Toutefois, leur manque d'aptitudes à l'adhésion et à la mouillabilité et leur perméabilité aux gaz restreignent leurs domaines d'application.

Il a été proposé divers traitements pour remédier à ces insuffisances des matériaux polymères, en particulier des matériaux plastiques, tels les polyoléfines. On a ainsi proposé d'appliquer à des pellicules en polyoléfine des traitements en phase liquide (sulfo-chromique), par plasma (décharge corona) ou par flamme pour améliorer leur aptitude à l'adhésion et à la mouillabilité, ainsi que d'effectuer sur de telles pellicules un dépôt de SiO₂ par dépôt en phase gazeuse sous plasma ou par pulvérisation cathodique, afin de réduire leur perméabilité aux gaz.

Ces traitements proposés (voir par exemple le document US-A-4.328.646 qui traite du dépôt de couches d'oxyde de silicium sur des aiguilles de gramophones) ne sont pas toutefois pleinement satisfaisants et laissent divers problèmes sérieux à résoudre comme la formation de polluants, la faible vitesse de traitement obtenue par les techniques en phase liquide, le manque d'uniformité et de sélectivité des traitements par flamme ou plasma, ou la nécessité de travailler sous vide pour effectuer un dépôt en phase gazeuse sous plasma ou par pulvérisation cathodique.

Il existe donc un besoin pour un procédé de traitement de substrats en un matériau polymère qui soit non-polluant et exécutable à une pression supérieure à 10 000 Pa, en ligne avec l'installation de fabrication du substrat, et qui permette d'améliorer les caractéristiques d'adhésion et d'imperméabilité aux gaz du substrat.

L'invention a pour objet de fournir un procédé de dépôt d'une couche d'oxyde de silicium liée à un substrat en un matériau polymère, notamment en matériau plastique et plus spécifiquement le polypropylène, le polyéthylène ou un copolymère de ceux-ci.

Plus particulièrement, l'invention concerne un procédé de dépôt d'une mince couche d'oxyde de silicium liée à un substrat en un matériau polymère, caractérisé en ce qu'il comprend, concomitamment ou successivement (1) la soumission d'une surface du substrat en matériau polymère à une décharge électrique à barrière diélectrique à une pression supérieure à 10 000 Pa et (2) l'exposition de ladite surface du substrat à une atmosphère contenant un silane à une pression supérieure à 10 000 Pa, grâce à quoi il se forme un dépôt d'oxyde de silicium lié à ladite surface du substrat.

Bien que l'invention ne soit pas liée à une théorie quelconque, une explication possible de la formation d'un dépôt d'oxyde de silicium sur le substrat ayant subi une exposition à une décharge électrique à barrière diélectrique est la suivante : la décharge électrique à barrière diélectrique exerce un bombardement d'électrons, d'espèces excitées ou chargées et/ou de radicaux sur la surface du substrat exposée à la décharge et ce bombardement crée des sites radicalaires sur la surface du polymère, lesquels réagissent ensuite avec le silane avec formation finale d'oxyde de silicium lors de l'exposition à l'air, à l'oxygène, ou éventuellement un autre gaz comportant de l'oxygène. Dans le cadre de la présente invention, on entend par silane un composé sous forme gazeuse dans les conditions de pression et de températures mises en oeuvre, et incluant au moins un atome de silicium. Un silane selon l'invention peut donc consister en un hydrure de silicium proprement dit, un hydrure de silicium halogéné, tels SiCl₄, SiH₂Cl₂, SiH₃Cl, SiHCl₃, un alkoxysilane tel le tétraéthoxysilane ou un organosiloxane.

Par "dépôt d'oxyde de silicium", on entend un dépôt de dioxyde de silicium pouvant contenir aussi un oxyde de silicium sous-stoechiométrique en oxygène.

A ce jour, les hydrures de silicium, tels SiH₄ ou Si₂H₆ sont préférés. SiH₄ est tout particulièrement préféré.

L'exposition du substrat traité par la décharge électrique à barrière diélectrique à l'atmosphère contenant un silane peut être effectuée concomitamment au traitement par la décharge électrique à barrière diélectrique en ménageant une atmosphère contenant un silane dans la zone où on effectue le traitement par la décharge électrique à barrière diélectrique ou successivement en assurant un contact entre la surface du substrat traitée par la décharge électrique à barrière diélectrique avec une atmosphère contenant le silane dans une zone faisant suite à la zone de traitement par la décharge électrique à barrière diélectrique.

Le traitement par décharge électrique à barrière diélectrique consiste à produire une décharge électrique entre deux électrodes, dont l'une au moins est recouverte d'un matériau diélectrique, tels le verre, l'alumine ou la silice. Un tel traitement est classique et connu en lui-même. Il peut notamment consister en une décharge luminescente ou "silent glow discharge" ou, de préférence, en une décharge couronne.

Le traitement par la décharge couronne est également un traitement classique bien connu en lui-même, cf. par exemple, l'article "The flexible adaption of the effective contact surface" de E. Prinz paru dans "Plastics Southern Africa", juin 1983, pages 50 et suivantes, et l'article "Traitement par effet corona, considérations techniques sur l'équipement de G. Tuffin paru dans "Plastiques Modernes et Elastomères, mai 1977, pages 54-56, qui donnent des indications sur le matériel à utiliser et les conditions opératoires. Le traitement par décharge électrique à barrière diélectrique, en particulier par décharge couronne, peut être réalisé dans de l'air, de l'azote, de l'oxygène, de l'argon, de l'hélium ou un mélange de ceux-ci lorsqu'on ne désire pas opérer concomitamment l'exposition au silane. Lorsqu'on désire effecuter concomitamment le traitement par le silane conduisant au dépôt d'oxyde de silicium, on peut effectuer le traitement par la décharge électrique à barrière diélectrique dans une atmosphère sensiblement neutre contenant le silane. Dans l'atmosphère neutre contenant le silane, ce dernier peut être dilué dans un gaz inerte, tel que l'azote, l'argon ou leur mélange, pour des raisons de sécurité. On pourra utiliser, par exemple, un mélange d'azote, d'argon et de silane comprenant, de préférence de 0,01 à 5 % en volume de silane. Dans le cas où l'exposition au silane est effectuée successivement au traitement à la décharge électrique par barrière diélectrique, le substrat traité sera mis en contact avec une atmosphère contenant le silane où le silane peut aussi être dilué par un gaz inerte tel que l'argon ; la concentration du silane étant aussi, de préférence, de 0,01 à 5 % en volume. La présence d'un peu d'air dans l'atmosphère contenant le silane peut être tolérée sans inconvénient dans certaines conditions, notamment lorsque la concentration en silane est inférieure à environ 2 %, que l'exposition au silane soit réalisée concomitamment ou non à la décharge électrique à barrière diélectrique.

La décharge électrique à barrière diélectrique peut se faire à une pression comprise entre 50 000 et 120 000 Pa, et de préférence à la pression atmosphérique, la température étant comprise généralement entre l'ambiante et la température de fusion du substrat traité. Lorsque l'exposition du substrat à l'atmosphère contenant le silane se fait successivement à la décharge électrique à barrière diélectrique, la pression de cette atmosphère peut également être comprise entre 50 000 et 120 000 Pa et de préférence sensiblement égale à la pression atmosphérique ; quant à sa température, elle-peut encore être comprise entre l'ambiante et la température de fusion du substrat.

La durée de contact du substrat traité par la décharge couronne avec l'atmosphère contenant le silane n'est pas critique et peut notamment être choisie en fonction de l'épaisseur du dépôt d'oxyde de silicium désirée. A titre indicatif, elle peut aller de 10⁻³ seconde à 1 minute ou plus.

Le procédé de l'invention peut être mis en oeuvre en ligne avec l'installation (par extrusion ou extrusion-soufflage par exemple) de fabrication du substrat en matériau polymère, ou être mis en oeuvre sur un substrat fabriqué et stocké avant traitement. Le substrat peut être par exemple, une feuille, une pellicule ou un article conformé. L'épaisseur du substrat n'est généralement pas critique et peut par exemple être comprise entre 5 µm et 2 cm, plus particulièrement entre 10 et 200 µm.

Le procédé de l'invention est utile pour traiter des substrats en matériau polymère synthétique ou naturel. A titre de matériau naturel, on peut citer la cellulose, le substrat traité pouvant alors être en papier ou en carton. Toutefois, les substrats en matériau polymère synthétique, en particulier en plastique, sont préférés dans le cadre de la présente invention. Parmi ces derniers, les plus avantageux sont en matériau thermoplastique, notamment en polyoléfine, tels le polyéthylène, le polypropylène ou le polystyrène, en polyéthylène téréphtalate, en polyamide, en polychlorure de vinyle ou en polycarbonate. Les substrats en polyoléfines sont tout particulièrement préférés dans le cadre de la présente invention.

L'analyse par spectroscopie électronique de pellicules traitées par le procédé de "l'invention a montré la présence d'un revêtement à base d'oxyde de silicium, de faible épaisseur, sur les pellicules.

L'existence d'une modification de la surface de pellicules traitées par le procédé de l'invention a aussi été démontrée par la méthode de la goutte d'eau. Cette méthode, bien connue, consiste à déposer une goutté d'eau (ou d'un autre liquide) à la surface de la pellicule à l'essai, puis à mesurer l'angle que fait celle-ci avec la surface. Cette méthode a montré que les pellicules traitées par le présent procédé donnent lieu à la mesure d'un angle plus petit que celui mesuré sur des pellicules non traitées ou traitées seulement par une décharge couronne, et ont donc des propriétés de mouillabilité améliorées.

Des essais préliminaires concernant les propriétés d'adhésion et de perméabilité aux gaz ont également révélé une amélioration des propriétés d'adhésion et une réduction de la perméabilité aux gaz de pellicules traitées selon l'invention par rapport à des pellicules-témoins non traitées.

L'exemple non limitatif ci-après est donné en vue d'illustrer l'invention.

### Exemple

On a traité un ruban de polypropylène d'une largeur de 30 mm et d'une épaisseur de 1 mm par un dispositif de traitement par décharge couronne en le faisant passer en continu, à une vitesse de 70 cm/minute, entre les électrodes du dispositif entre lesquelles on pouvait appliquer une tension maximale de 20 kV sous une fréquence minimale de 20 kHz. Les électrodes étaient formées d'une électrode supérieure en forme de couteau (lame de rasoir) et d'une électrode inférieure en forme de cylindre sur laquelle la pellicule défilait au cours de son passage entre les électrodes, l'interstice entre les électrodes étant d'environ 2 mm. Afin de pouvoir mettre le procédé de l'invention en oeuvre, étaient, en outre, prévues deux enceintes disposées au-dessus du ruban aussi prés que possible de ce dernier, la première coiffant l'électrode en forme de couteau et la seconde disposée à la suite immédiate de la première. La première enceinte pouvait soit être laissée remplie d'air, soit être balayée par un courant d'azote (auquel cas l'atmosphère régnant dans la première enceinte était constituée d'azote avec un peu d'air résiduel) ou par un mélange d'azote, et de SiH₄ dilué dans l'argon à 1% en volume de SiH₄ dans l'argon (auquel cas l'atmosphère régnant dans la première enceinte était constituée d'un mélange azote-argon-SiH₄-air résiduel contenant moins de 1% en volume de SiH₄ ) de manière à effectuer, à volonté, le traitement par décharge couronne dans l'une de ces atmosphères, tandis que la deuxième pouvait être remplie d'air lorsque l'atmosphère de la première enceinté était constituée du mélange azote-argon-SiH₄-air résiduel, ou balayée par un mélange d'argon et de SiH₄ à 1% en volume de SiH₄ (auquel cas l'atmosphère régnant dans la seconde enceinte était constituée d'un mélange argon-siH₄-air résiduel contenant moins de 1% en volume de SiH₄ ) dans le cas où la première enceinte était remplie d'air ou d'azote. La longueur de la première enceinte était suffisante pour coiffer les électrodes et ménager une distance d'environ 2 cm entre les électrodes et la sortie dû ruban à l'atmosphère. La longueur de la deuxième enceinte était telle que la durée de contact du ruban prétraité par la décharge couronne avec l'atmosphère argon-SiH₄-air soit de l'ordre de 20 secondes.

Le Tableau ci-dessous récapitule les conditions des essais et les résultats d'essais menés par la méthode de la goutte d'eau tant sur des rubans traités selon l'invention que sur des rubans non traités ou traités par la déchargé couronne seulement. L'effet d'un post-lavage sur divers rubans est également indiqué.

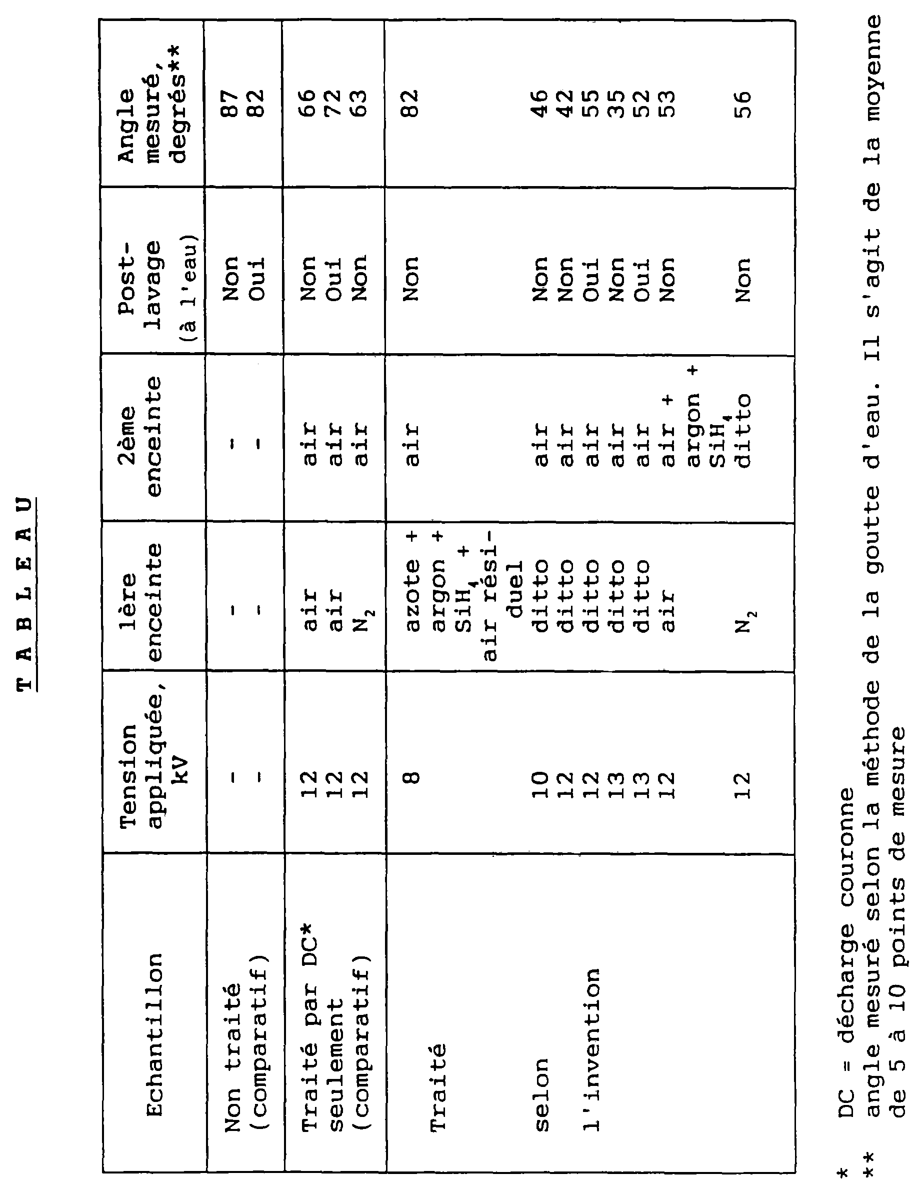

On peut voir, d'après ce Tableau, que les meilleurs résultats, quant à l'amélioration de la mouillabilité, sont obtenus dans les cas où le traitement par décharge couronne et l'exposition au silane sont effectués concomitamment et que les résultats sont d'autant meilleurs que la tension appliquée aux électrodes est plus élevée. Il est à remarquer, toutefois, que l'accroissement de tension possible est limité par les phénomènes de claquage qui peuvent se produire.

On peut remarquer aussi que le post-lavage des rubans traités par décharge couronne seulement ou par le procédé de l'invention tend à élever l'angle formé par la goutte d'eau avec la surface du matériau à l'essai, alors que, dans le cas du matériau non traité, elle le réduit. Cette différence de comportement n'est pas expliquée à l'heure actuelle. On peut aussi noter que, comme le matériau traité par une décharge couronne seulement présente le même comportement que les matériaux traités selon l'invention, le phénomène d'augmentation de l'angle induit par le post-lavage ne peut être expliqué uniquement par un enlèvement partiel de l'oxyde de silicium déposé, mais peut-être par un effet de vieillissement du traitement.

Les substrats obtenus par le procédé de l'invention peuvent trouver des applications dans divers domaines, par exemple dans l'emballage alimentaire en remplacement des pellicules aluminisées ou de films multicouches, où des propriétés de barrière sont requises, comme substrats pouvant être métallisés, peints, imprimés ou autrement pré-traités, etc...

Il va de soi que les modes de réalisation décrits ne sont que des exemples et qu'on pourrait les modifier, notamment par substitution d'équivalents techniques, sans sortir pour cela du cadre de l'invention.

## Revendications

1. Procédé de dépôt d'une mince couche d'oxyde de silicium liée à un substrat en un matériau polymère, caractérisé en ce qu'il comprend, concomitamment ou successivement (1) la soumission d'une surface du substrat en un matériau polymère à une décharge électrique à barrière diélectrique à une pression supérieure à 10 000 Pa et (2) l'exposition de ladite surface du substrat à une atmosphère contenant un silane à une pression supérieure à 10 000 Pa, grâce à quoi il se forme un dépôt d'oxyde de silicium lié à ladite surface du substrat.

2. Procédé selon la revendication 1, caractérisé en ce que la décharge électrique à barrière diélectrique est effectuée à une pression comprise entre 50 000 et 120 000 Pa.

3. Procédé selon la revendication 2, caractérisé en ce que la décharge électrique à barrière diélectrique est effectuée à la pression atmosphérique.

4. Procédé selon l'une des revendications 1 à 3, caractérisé en ce que ladite décharge électrique est une décharge couronne.

5. Procédé selon l'une des revendications 1 à 4, caractérisé en ce qu'on effectue concomitamment les opérations (1) et (2).

6. Procédé selon la revendication 5, caractérisé en ce qu'on réalise les opérations (1) et (2) de la façon suivante : on met en place, dans la zone où ledit substrat est soumis à la décharge électrique à barrière diélectrique, l'atmosphère contenant un silane.

7. Procédé selon l'une des revendications 1 à 4, caractérisé en ce qu'on effectue successivement les opérations (1) puis (2).

8. Procédé selon la revendication 7, caractérisé en ce que les opérations (1) et (2) sont réalisées de la façon suivante :
a) on soumet ledit substrat à la décharge électrique à barrière diélectrique dans une première zone où l'on a mis en place une première atmosphère d'air ou d'un gaz inerte,
b) on expose le substrat issu de l'étape a), dans une seconde zone faisant suite à la première zone, à l'atmosphère contenant un silane.

9. Procédé selon la revendication 8, caractérisé en ce que ladite première atmosphère de gaz inerte comprend un résiduel d'oxygène.

10. Procédé selon l'une des revendications 1 à 9, caractérisé en ce que ladite atmosphère contenant un silane comprend 0,01 à 5 % volumique dudit silane.

11. Procédé selon l'une des revendications 1 à 10, caractérisé en ce que le silane est un hydrure de silicium, un silane halogéné, un alkoxysilane.

12. Procédé selon la revendication 11, caractérisé en ce que ledit silane est un alkoxysilane : le tétraéthoxysilane.

13. Procédé selon la revendication 11, caractérisé en ce que ledit silane est SiH₄.

14. Procédé selon l'une des revendications 1 à 13, caractérisé en ce que ladite atmosphère contenant un silane comporte en outre un gaz inerte choisi parmi l'azote, l'argon, l'hélium ou un mélange de ceux-ci.

15. Procédé selon l'une des revendications 1 à 14, caractérisé en ce que ledit matériau polymère est naturel.

16. Procédé selon la revendication 15, caractérisé en ce que ledit polymère est la cellulose.

17. Procédé selon l'une des revendications 1 à 14, caractérisé en ce que ledit matériau polymère est synthétique.

18. Procédé selon la revendication 17, caractérisé en ce que ledit matériau polymère est un plastique.

19. Procédé selon la revendication 18, caractérisé en ce que ledit matériau polymère est un polyoléfine, un polyéthylène téréphtalate, un polyamide, un polychlorure de vinyle ou un polycarbonate.

20. Procédé selon l'une des revendications 1 à 19, caractérisé en ce que le substrat est une feuille ou une pellicule.

## Patentansprüche

1. Verfahren zur Abscheidung einer dünnen, mit einem Substrat aus polymerem Material verbundenen Siliziumoxidschicht, dadurch gekennzeichnet, daß gleichzeitig oder aufeinanderfolgend (1) eine Oberfläche des aus polymerem Material bestehenden Substrats einer Entladung über eine dielektrische Schicht bei einem Druck von mehr als 10000 Pa unterworfen und (2) die Substratoberfläche bei einem Druck von mehr als 10000 Pa einer silanhaltigen Atmosphäre ausgesetzt wird, dank der sich ein mit der Substratoberfläche verbundener Siliziumoxidniederschlag bildet.

2. Verfahren nach Anspruch 1, dadurch gekennzeichnet, daß die elektrische Entladung über die dielektrische Schicht bei einem Druck zwischen 50000 und 120000 Pa erfolgt.

3. Verfahren nach Anspruch 2, dadurch gekennzeichnet, daß die elektrische Entladung über die dielektrische Schicht bei atmosphärischem Druck erfolgt.

4. Verfahren nach einem der Ansprüche 1 bis 3, dadurch gekennzeichnet, daß die elektrische Entladung eine Koronaentladung ist.

5. Verfahren nach einem der Ansprüche 1 bis 4, dadurch gekennzeichnet, daß die Schritte (1) und (2) gleichzeitig ausgeführt werden.

6. Verfahren nach Anspruch 5, dadurch gekennzeichnet, daß die Schritte (1) und (2) auf die folgende Weise ausgeführt werden: die silanhaltige Atmosphäre wird in den Bereich eingebracht, in dem das Substrat der elektrischen Entladung über die dielektrische Schicht unterworfen wird.

7. Verfahren nach einem der Ansprüche 1 bis 4, dadurch gekennzeichnet, daß aufeinanderfolgend die Schritte (1) und dann (2) ausgeführt werden.

8. Verfahren nach Anspruch 7, dadurch gekennzeichnet, daß die Schritte (1) und (2) auf die folgende Weise ausgeführt werden:
(a) das Substrat wird der elektrischen Entladung über die dielektrische Schicht in einem ersten Bereich unterworfen, in den eine erste, Luft oder ein inertes Gas enthaltende Atmosphäre eingebracht wurde, und
(b) das aus der Stufe a) hervorgehende Substrat wird in einem sich dem ersten Bereich anschließenden zweiten Bereich der silanhaltigen Atmosphäre ausgesetzt.

9. Verfahren nach Anspruch 8, dadurch gekennzeichnet, daß die erste Atmosphäre aus inertem Gas einen Rest Sauerstoff enthält.

10. Verfahren nach einem der Ansprüche 1 bis 9, dadurch gekennzeichnet, daß die silanhaltige Atmosphäre 0,01 bis 5 Volumenprozent Silan enthält.

11. Verfahren nach einem der Ansprüche 1 bis 10, dadurch gekennzeichnet, daß das Silan ein Siliziumwasserstoff, ein halogenhaltiges Silan oder ein Alkoxysilan ist.

12. Verfahren nach Anspruch 11, dadurch gekennzeichnet, daß das Silan ein Alkoxysilan ist: das Tetraethoxysilan.

13. Verfahren nach Anspruch 11, dadurch gekennzeichnet, daß das Silan SiH₄ ist.

14. Verfahren nach einem der Ansprüche 1 bis 13, dadurch gekennzeichnet, daß die silanhaltige Atmosphäre außerdem ein aus Stickstoff, Argon oder Helium ausgewähltes inertes Gas oder ein Gemisch derselben enthält.

15. Verfahren nach einem der Ansprüche 1 bis 14, dadurch gekennzeichnet, daß das polymere Material ein Naturprodukt ist.

16. Verfahren nach Anspruch 15, dadurch gekennzeichnet, daß das polymere Material Zellulose ist.

17. Verfahren nach einem der Ansprüche 1 bis 14, dadurch gekennzeichnet, daß das polymere Material synthetisch ist.

18. Verfahren nach Anspruch 17, dadurch gekennzeichnet, daß das polymere Material ein Plast ist.

19. Verfahren nach Anspruch 18, dadurch gekennzeichnet, daß das polymere Material ein Polyolefin, ein Polyethylenterephtalat, ein Polyamid, ein Polyvinylchlorid oder ein Polykarbonat ist.

20. Verfahren nach einem der Ansprüche 1 bis 19, dadurch gekennzeichnet, daß das Substrat eine Folie oder ein dünner Überzug ist.

## Claims

1. Method for depositing a thin layer of silicon dioxide bound to a substrate made of a polymer, characterised in that it consists, concomitantly or successively (1), of subjecting a surface of the substrate made of a polymer to an electrical discharge with a dielectric barrier at a pressure greater than 10,000 Pa and (2) exposing the said surface of the substrate to an atmosphere containing a silane at a pressure greater than 10,000 Pa, by virtue of which a deposit of silicon dioxide bound to the said surface of the substrate is formed.

2. Method according to Claim 1, characterised in that the electrical discharge with a dielectric barrier is effected at a pressure between 50,000 and 120,000 Pa.

3. Method according to Claim 2, characterised in that the electrical discharge with a dielectric barrier is effected at atmospheric pressure.

4. Method according to one of Claims 1 to 3, characterised in that the said electrical discharge is a corona discharge.

5. Method according to one of Claims 1 to 4, characterised in that operations (1) and (2) are performed concomitantly.

6. Method according to Claim 5, characterised in that operations (1) and (2) are performed in the following manner:
the atmosphere containing a silane is established in the area where the said substrate is subjected to the electrical discharge with a dielectric barrier.

7. Method according to one of Claims 1 to 4, characterised in that operations (1) and then (2) are performed in succession.

8. Method according to Claim 7, characterised in that operations (1) and (2) are performed in the following manner:
a) the said substrate is subjected to the electrical discharge with a dielectric barrier in a first area where a first atmosphere of air or inert gas has been established,
b) the substrate coming from step a) is exposed, in a second area following on from the first area, to the atmosphere containing a silane.

9. Method according to Claim 8, characterised in that the said first atmosphere of inert gas comprises a remainder of oxygen.

10. Method according to one of Claims 1 to 9, characterised in that the said atmosphere containing a silane comprises 0.01 to 5% by volume of the said silane.

11. Method according to one of Claims 1 to 10, characterised in that the silane is a silicon hydride, a halogenated silane or an alkoxysilane.

12. Method according to Claim 11, characterised in that the said silane is an alkoxysilane: tetraethoxysilane.

13. Method according to Claim 11, characterised in that the said silane is SiH₄.

14. Method according to one of Claims 1 to 13, characterised in that the said atmosphere containing a silane also includes an inert gas chosen from amongst nitrogen, argon, helium or a mixture thereof.

15. Method according to one of Claims 1 to 14, characterised in that the said polymer is natural.

16. Method according to Claim 15, characterised in that the said polymer is cellulose.

17. Method according to one of Claims 1 to 14, characterised in that the said polymer is synthetic.

18. Method according to Claim 17, characterised in that the said polymer is a plastic.

19. Method according to Claim 18, characterised in that the said polymer is a polyolefine, a polyethylene terephthalate, a polyamide, a polyvinyl chloride or a polycarbonate.

20. Method according to one of Claims 1 to 19, characterised in that the substrate is a sheet or film.
